# EUROPEAN PATENT APPLICATION

(11) **EP 1 058 392 A1**
(43) Date of publication of application: **06.12.2000**
(21) Application number: 99110487.8
(22) Date of filing: 31.05.1999
(51) Int. Cl.: H03M 13/00

(54) **Method for implementing a plurality of add-compare-select butterfly operations in parallel, in a data processing system**

(71) Applicant: MOTOROLA, INC., Schaumburg, IL 60196 (US)
(72) Inventor: Tarrab, Moshe, Holon (IL); Rozenshein, Zvika, Kfar Saba (IL); Salant, Yoram, Rosh Haain (IL); Yosseff, Ronen, Petach Tikva (IL); Chass, Amir, Ramat Hasharon (IL); Kutz, Gideon, Tel Aviv (IL)
(74) Representative: Richardt, Markus Albert

(57) **Abstract**

A method for performing a plurality of compare-select butterfly operations in a data processing system, the performance of the plurality of add-compare-select butterfly operation requires a plurality of branch metrics, a plurality of previous path metrics and plurality of previous survivor paths. While performing the plurality of add-compare select butterfly operations, data related to the previous or next add-compare select butterfly operations are transferred.

## Description

### Field of the invention

Method for implementing a plurality of add-compare-select butterfly operation in parallel, in a data processing system, and especially in Very Long Instruction Word data processors.

### BACKGROUND OF THE INVENTION

The Viterbi algorithm is used for estimation and detection problems in digital communications and signal processing. The following references give some examples of various implementations of the Viterbi Algorithm : "Implementing the Viterbi Algorithm" by Hui-Ling Lou, IEEE Signal Processing Magazine, September 1990 pg. 42; "The Viterbi Algorithm" by G. David Forney, Jr., Proceedings of the IEEE, vol. 61, No. 3, March 1973, pg. 268. The Viterbi algorithm has gained wide acceptance in the area of communications, such as in cellular networks, modems, and satellite communications, for decoding convolutional codes, and for estimation and detection problems. Briefly, the Viterbi algorithm finds the most likely state transition in a state diagram, given a sequence of symbols. A plurality of states representing a given time is referred to as a stage. Each state is characterized by a path metric, and each transition from a state to another state is characterized by a branch metric. The path metrics and the branch metrics are measures of probability. At each state the Viterbi algorithm selects the best path by examining the accumulated metrics from all paths entering the state and selecting the path with the best metric, called a survivor path, that is the maximum-likelihood path through the trellis. The best path through the trellis may be the shortest path. The other path or paths are discarded.
In some implementations of the Viterbi algorithm the branch metrics are first calculated and stored in a table, and a plurality of add-compare-select (ACS) operations are executed to calculate the best path through the trellis for each state. An ACS operation is commonly known as an ACS butterfly. A typical ACS butterfly involves finding the best path from the j'th and the (j+2^{(v-1)})'th states of a previous stage to the 2j'th and the (2j+1)'th states of a current stage, wherein the maximum number of states within a stage is 2^{v}. Each new state is calculated sequentially by applying the ACS butterfly to the previous path metric using the stored branch metrics. The ACS butterfly operation is either involved or followed by the creation of new path metrics, associated to the survivor path. In one Implementation of the Viterbi algorithm, the new path metric equals the sum of the branch metric and the path metrics associated with the survivor path.

The amount of time and memory required to trace a path through a trellis depends on the size of the trellis. Very large trellis, are usually divided to portions, whereas each portion is decoded separately.

The Viterbi algorithm can be implemented in hardware or in software. When implemented in hardware, the Viterbi algorithm will generally run much faster than the Viterbi algorithm implemented in software. However, implementing the Viterbi algorithm in hardware is more expensive in terms of semiconductor surface area, complexity, and cost.

U.S. patent 5742621 of Amon describes a method for implementing a plurality of add-compare-select butterfly operations in a Viterbi decoder, the Viterbi decoder was implemented by a data processing system, and a Viterbi shift left instruction. US patent 5742621 described a Viterbi shift left instruction for performing a logical left shift to a trellis value in order to identify a survivor trellis state.

A disadvantage of the method described in U.S. patent 5742621 was that it was based on a relative long series of steps. In view of the increasing demand for faster methods for implementing the Viterbi algorithm, there is a need of a vary fast method for executing the add compare select butterfly operations in software.

### BRIEF DESCRIPTION OF THE DRAWINGS

While the invention is pointed out with particularity in the appended claims, other features of the invention are disclosed by the following detailed description taken in conjunction with the accompanying drawings, in which:
FIG. 1 is a block diagram of a data processing system, according to an embodiment of the invention;
FIG. 2 is a diagram that illustrates registers within the core of the system of FIG. 1;
FIG. 3 is a schematic diagram of the data register files, four arithmetic logic units and a shifter/limiter;
FIG. 4 is a diagram that illustrates a particular embodiment of the one of the MAC units of FIG. 1;
FIG. 5 is a diagram that illustrates a dispatch unit, and a dispatch operation for the core of the system of FIG. 1;
FIG. 6 illustrates in flow chart form, ACS butterfly operation within a Viterbi decoder, in accordance with the present invention;
FIG. 7 illustrates is a schematic form, the content of a portion of an internal memory module of the system of FIG. 1, in accordance with the present invention; and
FIG. 8 illustrates in flow chart form, ACS butterfly operation within a Viterbi equalizer, in accordance with the present invention.

### DESCRIPTION OF THE PREFERRED EMBODIMENT

Generally, the present invention provides a parallel data structure, a multi arithmetic logic unit system and a dedicated add, subtract, compare and select, and parallel Viterbi specific shift left instructions for minimizing the number of clock cycles required for performing the Viterbi algorithm.

Specifically, the parallel data structure, the multi arithmetic logic unit system and the dedicated add, subtract, compare and select, and parallel Viterbi specific shift left instructions reduce the number of clock cycles in a data processing system that performs an ACS butterfly operation in a data processing system for choosing the best path through a trellis diagram.

It should be noted that the particular terms and expressions employed and the particular structural and operational details disclosed in the detailed description and accompanying drawings are for illustrative purposes only and are not intended to in any way limit the scope of the invention as described in the appended claims.

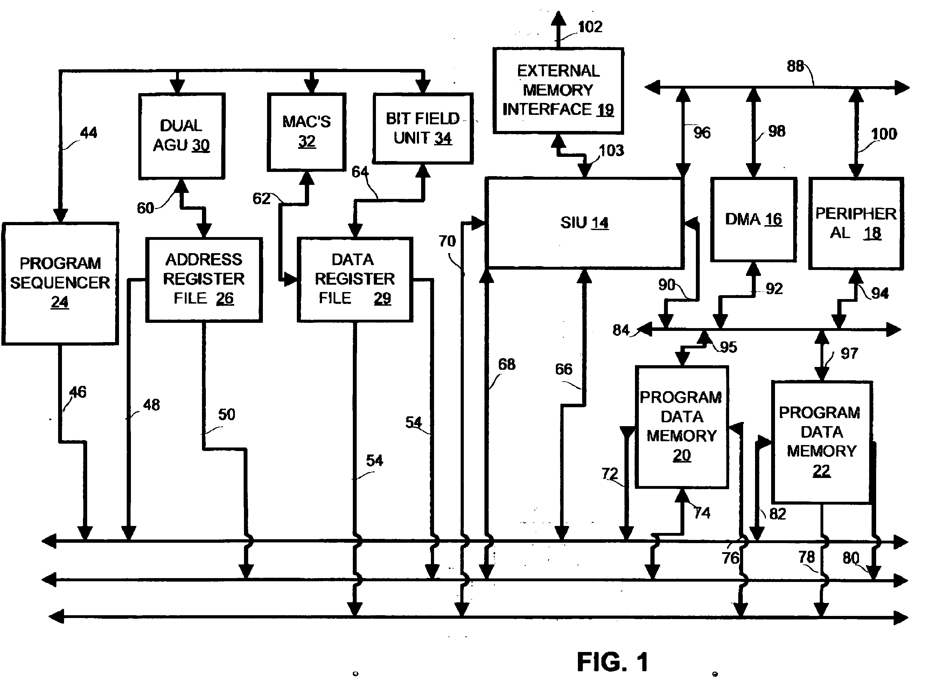

Referring to FIG. 1, an embodiment of a processing system 10 is illustrated. The processing system 10 includes a processor core 12, a system interface unit (SIU) 14, a direct memory access unit 16, a peripheral 18, such as a serial communication port or timer, internal memory modules 20, 22, and an external memory interface module 19. The processing system 10 may also be referred to as a data processor.

Processor core 12 includes address register file 26, program sequencer 24, data register files 28, 29, address arithmetic logic units 30 (also referred to as address generation units (AGU)), multiply and accumulate (MAC) units (32) (also referred to generally as data arithmetic logic units (DALU)), AND bit field and logic unit 34. The address ALUs 30 are coupled to the address register file 26 via internal bus 60. The multiply and accumulate units 32 are coupled to the data register files 28, 29 via internal bus 62, and bit field unit 34 is coupled to the data register files 28, 29 via internal bus 64. The program sequencer 24 is coupled via the instruction bus 44 to the address ALUs 30, the DALUs 32, the bit field unit 34, and the instruction expansion accelerator 36.

The system 10 further includes program bus 38, first data bus 40, second data bus 42, peripheral bus 88, direct memory access (DMA) bus 84, and external memory interface bus 102. Program bus 38 is coupled to program sequencer 24 via bus 46, to SIU 14 via bus 66, and to internal memory 20, 22 via buses 72 and 82 respectively. Data buses 40, 42 are coupled to address register file 26 via buses 48, 50, to data register files 28, 29 via buses 52, 54, and to instruction expansion accelerator 36 via buses 56, 58. Data buses 40, 42 are coupled to memory 20, 22 via buses 74-80.

DMA bus 84 is coupled to SIU 14 via bus 90, to DMA 16 via bus 92, to peripheral unit 18 via bus 94, and to memory units 20, 22 via buses 95 and 97 respectively. Peripheral bus 88 is coupled to the SIU 14 via bus 96, to DMA 16 via bus 98, and to peripheral unit 18 via bus 100. External memory bus 102 is coupled to external memory interface module 19 and is coupled to external memory (not shown) in communication with the system 10. In the illustrated embodiment, the program bus 38 is 128 bits wide, and the other buses 40, 42, 84, and 88 are 64 bits wide. For convenience of explanation, the buses which are used to exchange addresses were not shown.

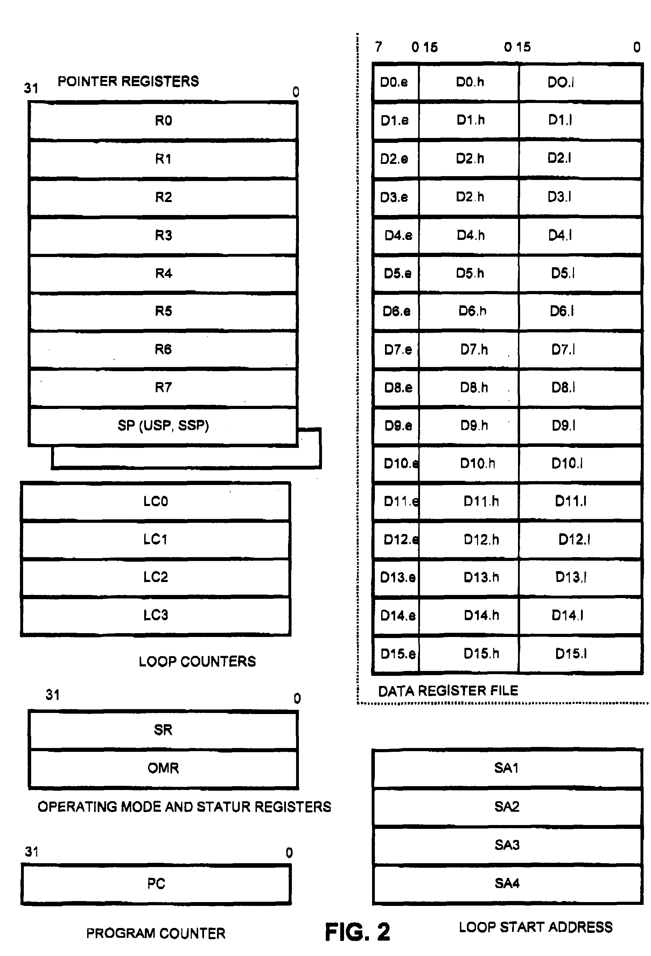

Referring to FIG. 2, a particular embodiment of registers within the core 12 of the system 10 is disclosed. As illustrated, the address register file 26 includes registers R0-R7, stack pointer (SP), N0-N3, M0-M2, MCTL, SA0-SA3, LC0-LC3. The program sequencer 24 includes the program counter, status register, and operating mode and status registers. The data register file 28 includes registers D0-D7 and the data register file 29 includes registers D8-D15. In an alternative embodiment, only a single register file may be used to save cost, such as with the one or two MAC configurations. In other high performance applications, more than two register files may also be used.

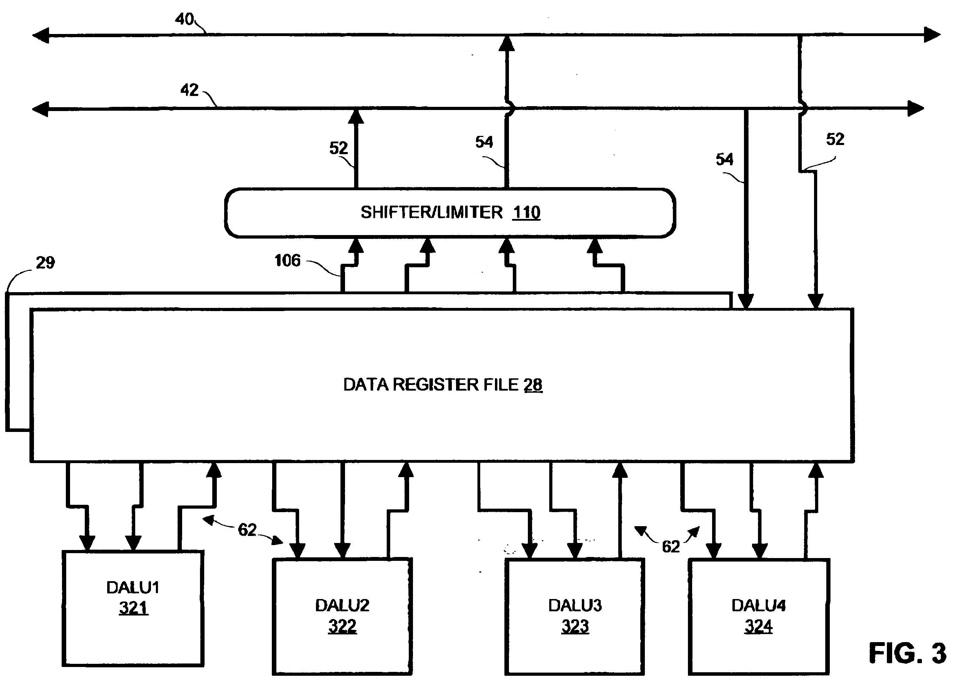

FIG. 3 is a schematic diagram of the data register files, four ALU units and shifter/limiter. It is to be understood that the present invention is not to be limited by the above exemplary configurations and is not limited to the particular number of MAC units 32 or the particular arrangements thereof. Shifter/limiter 110 is used to perform a Viterbi shift left operation on the survivor trellis value, and to insert a predetermined bit to the least significant bit of the survivor trellis value.

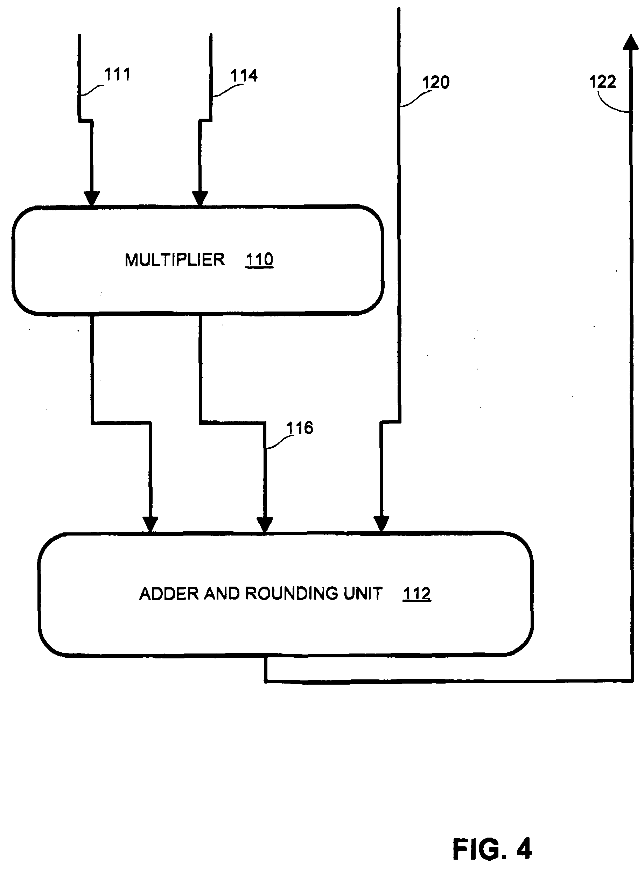

Referring to FIG. 4, a particular embodiment of a MAC unit 32 is illustrated. The MAC unit 32 includes a multiplier 110 and an adder 112. The multiplier 110 receives data input from the data register files 28, 29, and multiplies the data elements 111, 114 to produce a multiplied output 116 that is input to the adder 112. The adder sums a second data input 120 and the multiplier result 116 to produce an accumulated result 122 that is output back to the data register file 28, 29.

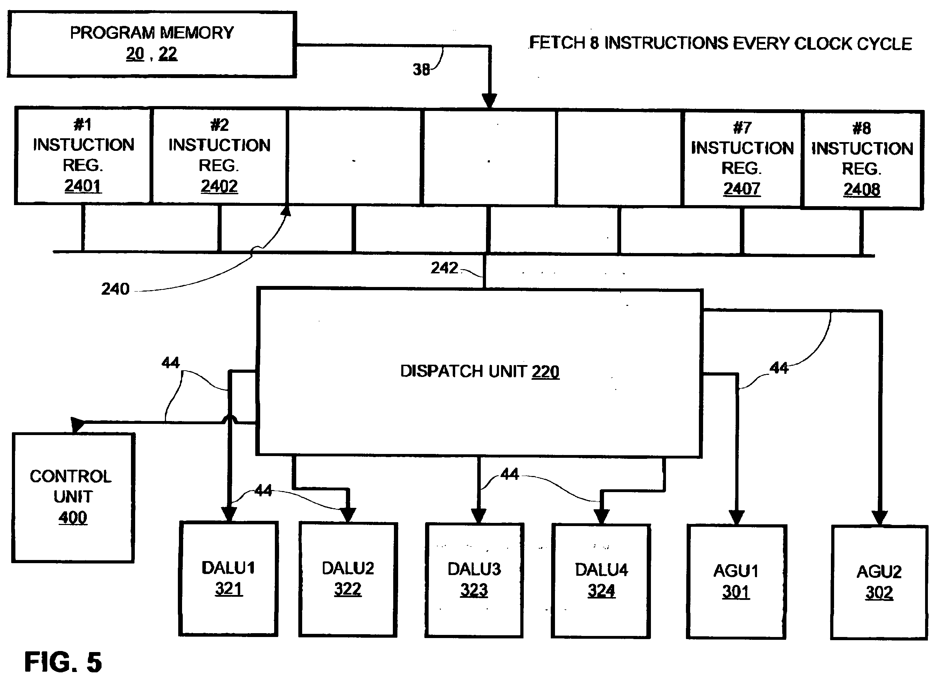

Referring to FIG. 5, illustrating a dispatch unit, and a dispatch operation for the core of the system of FIG. 1. Internal memory 20 and 22 store instruction fetch sets. Preferably, each instruction fetch set comprises of fixed number of instructions. An instruction execution set is usually a subset of an instruction fetch set, usually a single instruction fetch set is comprised of a single instruction execution set, but can also have instructions from other instruction execution sets. An instruction execution set comprises of a plurality of instructions which can be executed in parallel by the various execution units within system 10.

The embodiment illustrates a dispatch unit 220, eight instruction registers 2401-2409, collectively denoted 240, for storing eight instructions every clock cycle, a program memory (either program memory 20 or 22), various data arithmetic logic units (DALUs) 321-324 (collectively denoted 32 in FIG. 1), address generation units (AGUs) 301-302, 324 (collectively denoted 30 in FIG. 1), and control unit 400. The dispatch unit 220 and instructions registers 240 may form the program sequencer 24. In the illustrated embodiment, dispatch unit 220 groups the instructions into execution sets, and then simultaneously dispatched them via a routing mechanism to the appropriate execution units 301-302, 321-324, for parallel decoding and execution. Simultaneous dispatch means that execution of each of the grouped instructions is initiated during a common clock cycle. In the illustrated embodiment of the system 10, execution of each of the grouped instructions is initiated during a common clock cycle, but one or more of the grouped instructions may complete execution during a different clock cycle.

System 10 uses a pipeline execution method that includes the execution stages of program pre-fetch, program fetch, dispatch and decode, address generation , and execute.

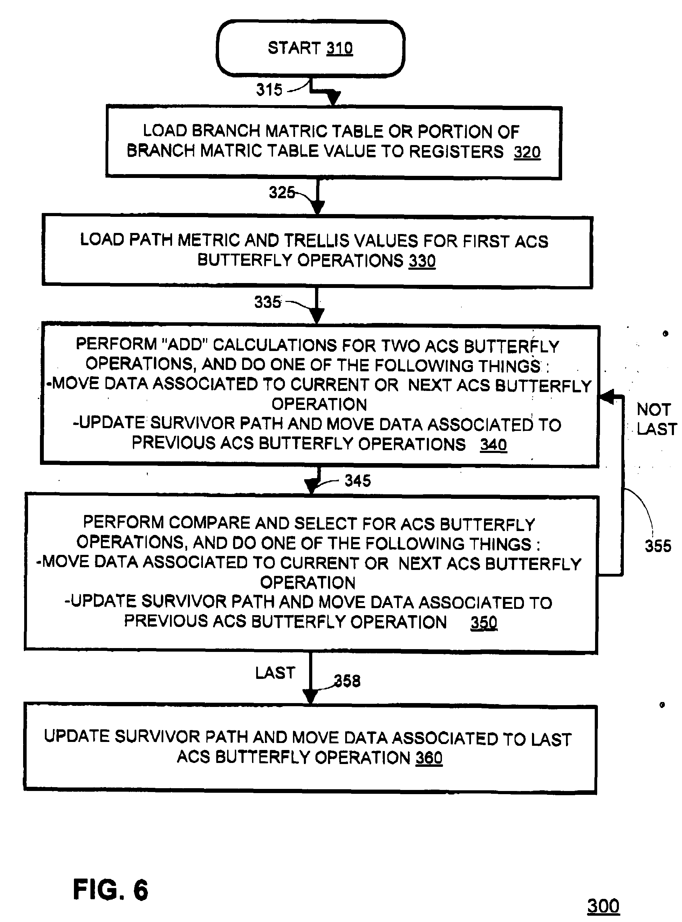

FIG. 6 illustrates in flow chart form, method 300 for implementing ACS butterfly operation within a Viterbi decoder, in accordance with the present invention. Rectangular boxes 310, 320 and 330 represent initialization steps that are followed by rectangular boxes 340, 350 and 360. Rectangular boxes 340 and 350 represent steps which are followed in order to perform one iteration, or loop, of the ACS butterfly for a data processing system that uses the Viterbi decoder algorithm to find the best path from a previous state to a present state of a trellis. Rectangular box 360 represents a step that is performed after the completion of the last iteration of steps 340 and 350. In one embodiment, the ACS butterfly is included as a DO loop within a set of instructions for decoding convolutional codes using the Viterbi decoder algorithm.

The ACS butterfly performs the calculations required to select the path through the trellis that represents the most likely sequence that was generated by a convolutional encoder. A plurality of the ACS butterfly operations are repeatedly executed a predetermined number of times, or iterations, to calculate the best path through the trellis for each stage. System 10 has the ability to execute a plurality of ACS butterfly operations in parallel. Each new state is calculated sequentially by applying the ACS butterfly to the previous path metric using the stored branch metrics.

Note that there are several known methods for calculating the most likely sequence through the trellis. The method of the illustrated embodiment requires maximizing accumulated path metrics by choosing the path metric with the largest value. Other embodiments may require minimizing accumulated path metrics to choose the shortest path through the trellis. Some methods use the Eucledian distance as a distance measure, while other methods use the Hamming distance as a distance measure.

Prior to the performance of the ACS butterfly operation, branch metrics are first calculated and stored in internal memory module 20 or 32, pointer by an effective address stored in register R1, located in address register file 26. The calculation can be performed during initialization step "START" 310.

For convenience of explanation it is assumed that branch metrics, path metric and trellis values are stored in internal memory module 20.

Each branch metric is defined as a measure of distance determined by some form of comparison between a received input signal and a corresponding branch in the trellis diagram. The term "signal" refers to information communicated between an encoder of a transmitter and a decoder of a receiver of a communications system. The branch metrics are stored in a table, denoted as branch metric table. The whole branch metric table can be stored within the data register file, thus there is no need to fetch portions of the branch metric table during stages 340 and 350. Preferably, a portion of the branch metric table is stored within the data register file. Other portions of the table metrics are fetched during either step 340 and 350.

For convenience of explanation it is assumed that the convolutional code has a constraint length of five and a rate of 1/2, and that the first two ACS butterflies calculation involve the first, second, ninth and tenth states (PM0o, PM1o, PM8o, PM9o) of a previous stage, the first, second third and fourth states (PM0n, PM1n, PM2n,PM3n) of the next stage, and the first and second branch metrics BM0, BM1. The survivor paths associated with the first, second, ninth and tenth states of the previous stage are denoted T0o,T1o,T8o,T9o.

As indicated by path 315, step 310 is followed by step 320. During step 320 the branch metric table is moved into a plurality of registers located in data register files 28,29 . Preferably a portion of the branch metric table is moved to a plurality of registers located in the data register files 28,29. At step 320, four branch metrics BM0-BM3, which are used in the next four ACS butterfly operations are moved into registers D4 and D5, from a predetermined location of internal memory module 20, that is pointed to by an effective address stored in register R1. The effective address is incremented by one.

As indicated by path 325, step 320 is followed by step 330. In step 330 four previous path metrics, and four survivor paths, which are used in the next first two ACS butterfly operations are moved into registers D0, D2, D1 and D3. The 16 least significant bits of registers D0-D15 are referred to as D0.l - D15.l accordingly, the 16 bits which follow D0.l - D15.l are referred to as D0,h - D15.h, accordingly.

After step 330 is executed, D0.l stores PM0o, D0.h stores PM1o, D1.l stores T0o, D1.h stores T1o, D2.l stores PM8o, D2.h stores PM9o, D3.l stores T8o, D3.h stores T9o, D4.l stores BM0, D4.h stores BM1, D6.l stores BM0, D6.h stores BM1.As indicated by path 335, step 330 is followed by step 340.

Step 340 is the first step of a DO loop for the ACS butterfly operation. At step 340, the "Add" operations for two ACS butterflies are performed in parallel, and preferably in the same single clock cycle. The content of D0.l is added to the content of D4.l and the result is stored in D4.l. The content of D0.h is added to the content of D4.h, and the result is stored in D4.h. The content of D6.l is added to the content of D2.l, and the result is stored in D6.l. The content of D6.h is added to the content of D2.h, and the result is stored in D6.h. The content of D6.l is subtracted from the content of D2.l and the result is stored in D2.l. The content of D6.h is subtracted from to the content of D2.h and the result is stored in D2.h. The content of D4.l is subtracted from the content of D0.l and the result is stored in D0.l. The content of D4.h is subtracted from to the content of D0.h, and the result is stored in D0.h.

After step 340 is executed, D0.l stores PM0o-BM0, D0.h stores PM1o-BM1, D2.l stores PM8o-BM0, D2.h stores PM9o-BM1, D4.l stores BM0+PM0o, D4.h stores BM1+PM1o, D6.l stores BM0+PM8o, D6.h stores BM1+PM9o.

During step 340, and in parallel to these add and subtract operation, a block of data is moved either from data register files 28,29 to internal memory module 20 or vice verse. The block of data which is moved to data register file can comprise of: a portion of the branch metric table, to be used in the next ACS butterfly operations, the portion being moved to the data register file; a plurality of previous path metrics and the survivor paths, to be used in the next ACS butterfly operations, moved to data register file. The block of data which is moved to internal memory module 20, usually comprises of a plurality of the updated survivor paths, and the new path metrics, associated to the survivor path metrics.

The survivor paths are updated by using shifter/limiter 110. A survivor path entering a state is updated after the ACS operation involving this state was performed during step 350, in one of the previous iteration of the DO loop. Each survivor path is moved to the least significant bits of shifter/limiter 108, which performs a logical left shift on the survivor path, and a bit indicating which signal was most likely generated by the convolutional encoder is loaded into the least significant bit of shifter/limiter 108. Conveniently, this bit is provided from either of flags VF0-VF3. Preferably, this update is done in the same clock signal in which the updated survivor paths are sent to a predetermined memory location of internal memory module 20, whereas this location is pointed to by an effective address stored in register R4.

As indicated by path 345, step 340 is followed by step 350. During step 350 the first, second, ninth and tenth previous path metrics PM0o, PM1o, PM8, PM9o are examined in view of the branch metric BM0, BM1 to determine the four survivor paths. Four flags, VF0-VF3 indicate which paths are the survivor paths. The result in D0.h (PM1o-BM1) is compared to the result in D6.h (PM9o+BM1). If the former is greater than the latter, the content of D0.h is moved to D6.h, and a fourth flag VF3 is reset, else VF3 is set. The result in D0.l (PM0o-BM0) is compared to the result in D6.l, (BM0+PM8o), if the former is greater than the latter then the content of D0.l is moved to D6.l, and a third flag VF2 is reset, else VF2 is set. The result in D4.h (PM1o+BM1) is compared to the result in D2.h (PM9o-BM1) and if the former is greater than the latter then the content of D4.h is moved to D2.h, and a second flag VF1 is reset, else VF1 is set. The result in D4.l (PM0o+BM0) is compared to the result in D2.l (PM8o-BM0) and if the former is greater than the latter then the content of D4.l is moved to D2.l and a first flag VF0 is reset, otherwise VF0 is set. Thus, flags VF0-VF3 indicate where the survivor paths and the corresponding path metrics are stored. The survivor paths will be updated during a further iteration of steps 340 and 350 or during step 360 in which the survivor path is updated and the updated survivor paths and the new path metrics are sent to internal memory module 20. Usually step 360 follows step 350 after the ASC butterfly calculations of an entire stage is done. As long as there is there are additional ACS butterfly operations to execute, step 350 is followed by step 240, as indicated by path 355.

In the case where a result in D0.h, D0.l, D4h, D4l is equal to a result in D6.h, D6.l, D2.h, D2.l accordingly, there are several ways to determine the survivor path. For example, the determination may be arbitrary. However, this determination is not important for describing the invention and will not be discussed further.

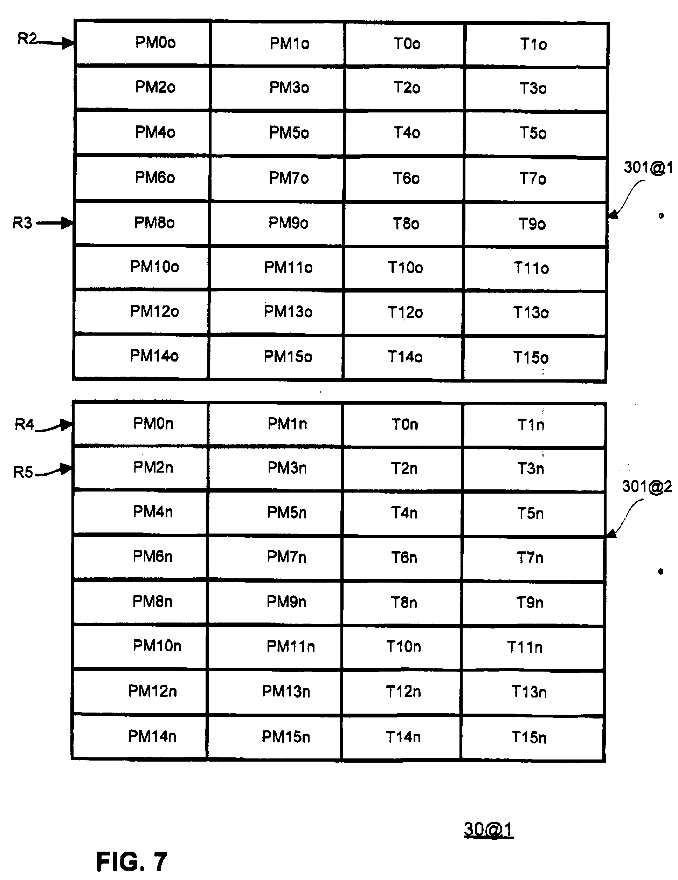

FIG. 7 illustrates is a schematic form, the content of a portion 30@1 of internal memory module 20 in accordance with the present invention.

Portion 301 comprises of a contiguous set of memory locations which is accessed as a circular buffer. Portion 301 is divided to two blocks 301@1 and 301@2. Each block contains eight groups. Each group is comprised of four consecutive memory bytes.

One block stores data such as survivor paths and path metrics associated with a pervious stage while the other block stores data associated with the next stage. After the data of the next stage is updated, the former block stores data associated with a next stage while the latter block stores data associated with the previous stage.

For convenience of explanation it is assumed that first block 301@1 stores data associated with the previous stage (PM0o - PM15o, T0o - T15o), while second block set 301@2 stores data associated with the next stage (PM0n - PM15n, T0n - T15n).

A branch metric table or a portion of the table are stored in a predetermined location of internal memory module 20, that is pointed to by an effective address stored in register R1.

Resisters R2 and R3 store pointers to memory locations located in first block 301@1, these memory locations store the survivor paths and the path metrics of a previous stage, required to perform two ACS butterfly operations. For example, R2 stores a pointer to the first group of first block 310@1 which stores PM0o, PM1o, T0o, and T1o. R3 stores a pointer to the fifth group of first block 310@1 which stores PM9o, PM8o, T8o and T9o.

Resisters R4 and R5 store pointers to memory locations located in second block 301@2, these memory locations will store the trellis values and the path metric of the next stage. For example, R4 stores a pointer to a set of two 16-bits memory words which store PM0n, PM1n, T0n, and T1n. R5 stores a pointer to a set of two 16-bits memory words which store PM2n, PM3n, T2n and T3n.

After the survivor paths and the path metric are moved to registers in data register file 28, 29 , R2 and R3 are incremented by a predetermined constant, for pointing to two groups which contain data required for the next two ACS butterfly operations. For example, after pointing to the first and fifth groups, R2 and R3 are incremented by 2, so that R2 points to the second group and R3 points to the sixth group of first block 310@1.

Registers R4 and R5 point to the first and second groups of second block 310@2, which store the survivor paths and the path metric of a next stage (PM0n, PM1n, T0n,T1n, PM2n, PM3n, T2n, T3n) after the data pointed by R2 and R3 undergoes two ACS butterfly operations. R4 and R5 are then incremented by a predetermined value, causing them to point to two groups that will contain the next results of two ASC butterfly operations. For example, after pointing to the first and second groups of second block 310@2, R4 and R5 are incremented by 4, causing them to point to the third and fourth groups of second block 310@2.

Usually, a plurality of ASC butterfly operations are grouped together in order to reduce the number of initialization steps required for the execution of a plurality of ACS butterfly operations and in order to utilize in a efficient manner the capability to transfer data relating a ACS operation while performing another ACS operation.

An exemplary assembly code (written in capital letters), and a detailed explanation of each code line, and of each instruction are shown. This assembly code performs 8 ACS butterfly operations :

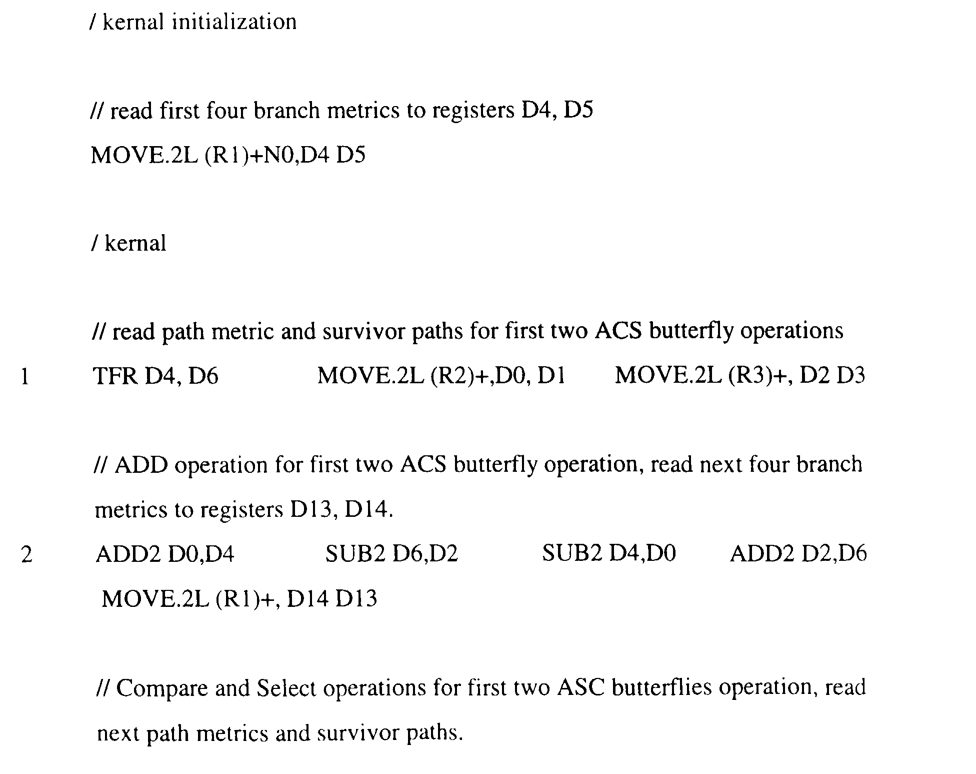

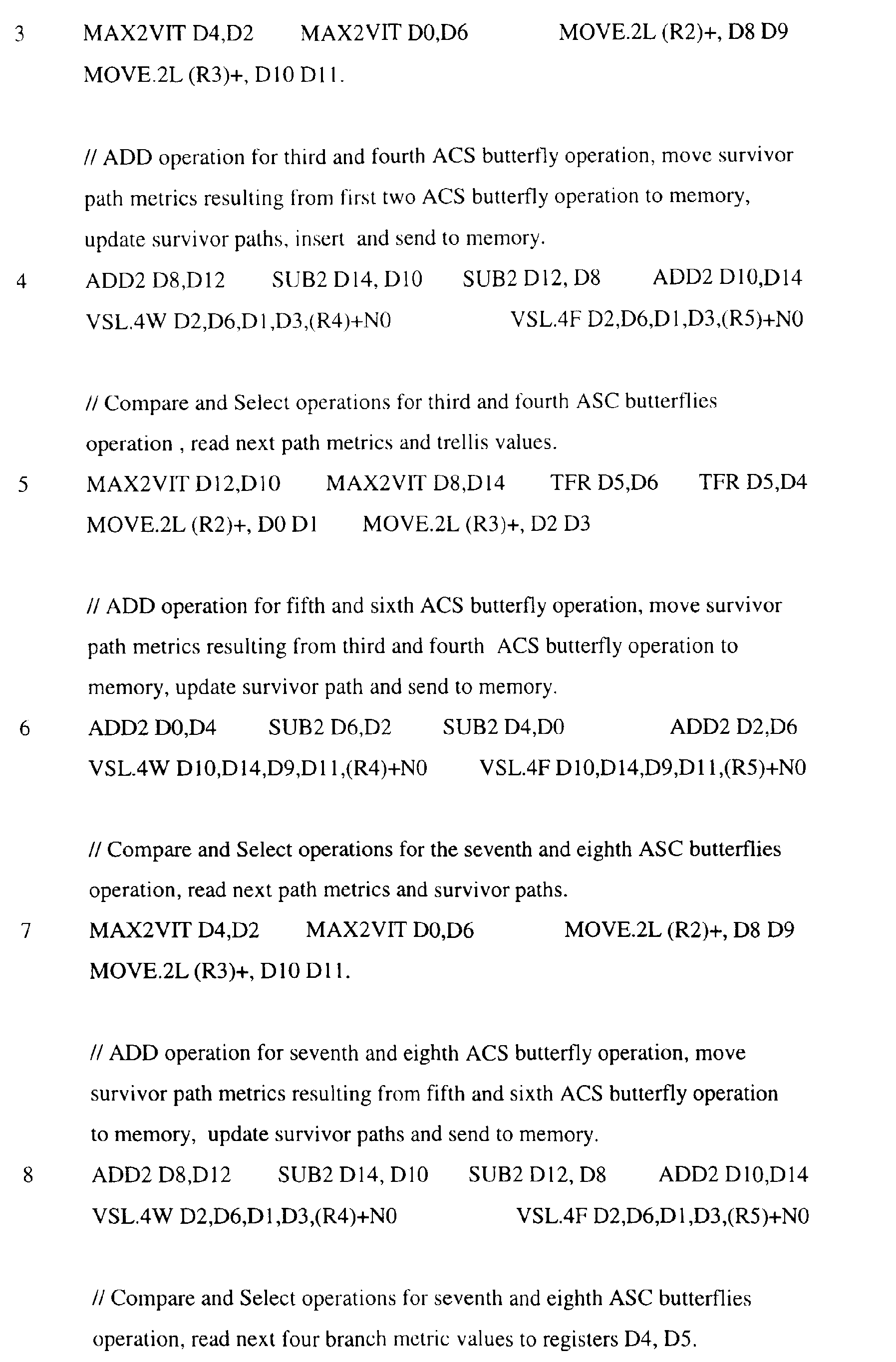

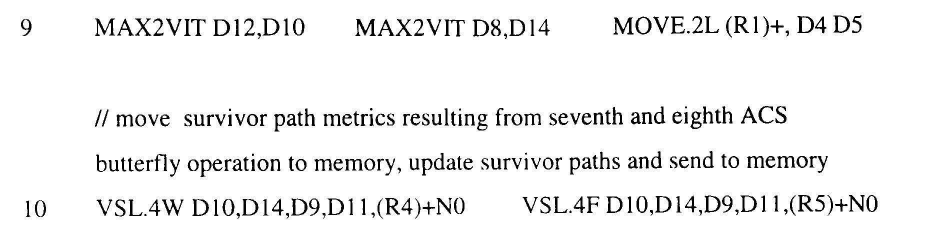

The instructions which formed the exemplary code perform the following operations :

MOVE.2L (R)+N0, D1 D2 instruction moves two 16-bit words from a memory location within internal memory module, pointed by register R, to destination registers D1 and D2. The content of register R in incremented by N0 after the two words are moved to registers D1 and D2. MOVE.2L is the operation code.

R, D1, D2 and D3,D4 are registers which are located either in address register 26 file and the data register files 28, 29.

TFR D1,D2 instruction transfers the content of a register D1 to register D2. TRF is the operation code.

ADD2 D1 D2 adds the content of the F/2 most significant bits (i.e.- D1.h) of F- bit register D1 to the F/2 most significant bits of register D2 (i.e.- D2.h), stores the result at D1.h, adds the content of the F/2 least significant bits (i.e.- D1.l) of register D1 to the F/2 least significant bits of register D2 (i.e.- D2.l) and stores the result at D1.l. Carry is disabled between the F/2 least significant bit and the F/2 most significant bit of D2. ADD2 is the operation code.

SUB2 D1 D2 subtracts the content of the D2.h from D1.h, stores the result at D1.h, subtracts the content of D2.1 from the content of D1.l and stores the result at D1.l. Carry is disabled between the F/2 least significant bit and the F/2 most significant bit of D2. SUB2 is the operation code.

MAX2VIT D1 D2 performs two comparisons. It compares between the contents of D1.l and D2.l, and if the former is greater than the latter the content of the is moved to D2.l and a flag is reset, else the flag is set. It also compares between the contents of D1.h and D2.h, and if the former is greater than the latter the content of the is moved to D2.h and another flag is reset, else the other flag is set. The flags indicate where the survivor paths are stored. Preferably, the registers which their content is involved in the comparison determine which flags are set/reset as a result of the two comparisons. For example, MAX2VIT D4 D2 can set/reset first and second flags VF0 and VF1 and MAX2VIT D0 D6 can set/reset third and fourth flags VF2 and VF3. MAX2VIT is the operation code.

VSL.4W D1:D2:D3:D4, (R)+N0 moves the content of D1.l to a first predetermined location of internal memory module 20, that is pointed to by an effective address stored in register R; moves the content of D2.l to a second predetermined location of internal memory module 20; performs a logical shift logical left on the survivor path and inserts a predetermined bit in the least significant bit, the location of the survivor path (either D3.l or D4.l) is determined by the flags, and sends the updated survivor paths to a third and fourth predetermined location in memory. Conveniently, the distance between the first, fourth, third and fourth predetermined locations in internal memory module 20 is N0. The content of R is incremented by 8*N0. For example, VSL.4W D2:D6:D3:D1 moves the content of D2.l and D6.l to first and second locations in internal memory module 20 and if VF0=0 then it updates the trellis value stored in D1.l by performs a logical left shift and inserting 0 to the least significant bit, and moves the updated trellis value to a predetermined location in internal memory module 20. If VF0=1 it updates the content of D3.l and moves the updated trellis value, wherein the least significant bit equals "1", to a predetermined location in internal memory module 20. If VF2=0 then it updates the survivor path stored in D1.l by performs a logical left shift and inserting 0 to the least significant bit, and moves the updated trellis value to a predetermined location in internal memory module 20. If VF2=1 it updates the content of D3.l and moves the survivor path, wherein the least significant bit equals "1", to a predetermined location in internal memory module 20

VSL.4H D:1D2:D3:D4, (R)+N0 is analogues to VSL.4W but operates on the upper half (D1.h,D2.h,D3.h,D4.h) of the registers, and also checks other flags in order to determine whether the survivor trellis values are located in D3.h or D4.h. For example, VSL.4F D2:D6:D3:D1 moves the content of D2.h and D6.h to two predetermined locations in internal memory module 20 and if VF1=0 then it updates the survivor path stored in D1.h by performs a logical left shift and inserting 0 to the least significant bit, and moves the updated survivor path to a predetermined location in internal memory module 20. If VF1=1 it updates the content of D3.h and moves the updated trellis value, wherein the least significant bit equals "1", to a predetermined location in internal memory module 20. If VF3=0 then it updates the survivor path stored in D1.h by performs a logical left shift and inserting 0 to the least significant bit, and moves the updated survivor path to a predetermined location in internal memory module 20. If VF3=1 it updates the content of D3.h and moves the updated survivor path, wherein the least significant bit equals "1", to a predetermined location in internal memory module 20

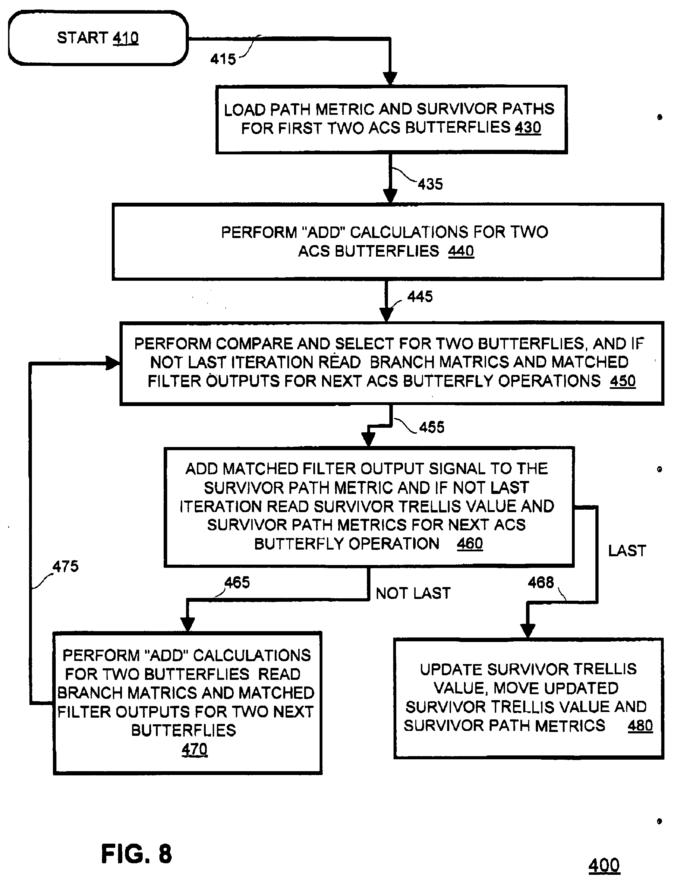

FIG. 8 illustrates in flow chart form, method 400 for implementing ACS butterfly operation within a Viterbi equalizer, in accordance with the present invention. The Viterbi equalizer detects symbols which were corrupted by noise. Method 400 is analogues to method 300 but involves the calculation of the branch metrics, and fetching output signals of a matched filter.

Rectangular boxes 410, 430 and 440 represent initialization steps which are followed by rectangular boxes 450, 460 and 470. Rectangular boxes 450 and 460 and 470 represent steps which are followed in order to perform one iteration, or loop, of the ACS butterfly for a data processing system that uses the Viterbi algorithm to find the best path from a previous state to a present state of a trellis. Rectangular box 480 represents a step which is performed after the completion of the last iteration of steps 450 and 460. In one embodiment, the ACS butterfly is included as a DO loop within a set of instructions for detecting symbols which were corrupted by noise, using the Viterbi decoder algorithm.

The ACS butterfly performs the calculations required to select the path through the trellis that represents the most likely sequence that was transmitted via a communication channel and was corrupted by noise and by intersymbol interference . A plurality of the ACS butterfly operations are repeatedly executed a predetermined number of times, or iterations, to calculate the best path through the trellis for each stage. System 10 has the ability to execute a plurality of ACS butterfly operations in parallel. Each new state is calculated sequentially by applying the ACS butterfly to the previous path metric using the stored branch metrics.

Each branch metric is the sum of a predetermined branch metris and the output signal of a matched filter. Prior to the performance of the ACS butterfly operation, the predetermined branch metrics are calculated and stored in internal memory module 20 or 32, pointed by an effective address stored in register R1, located in address register file 26. The calculation can be performed during initialization step "START" 410.

The predetermined branch metrics are stored in a table, denoted as predetermined branch metric table. The predetermined branch metrics which are associated with the transition from a current stage to the next stage are equal throughout the whole trellis. Furthermore, the branch metrics associated with the upper half of the states of each stage equal the branch metrics associated to the lower half of each stage. For example, if each stage has 16 states, and there are 96 stages, and the predetermined branch metric which is associated to the transition from the s'th state of the t'th stage to the l'th state of the (t+1)'th stage is denoted as PBMs,l,t then PMB1,1,1 = PMB1,1,2 = PMB1,1,3 = ... = MB1,1,96 = PMB16,16,1 = PMB16,16,2 = PMB16,16,3 = ... = PMB16,16,96 = - PMB1,2,1 = - PMB1,2,2 = -PMB1,2,3 = ... = -MB1,2,96 = -PMB16,15,1 = -PMB16,15,2 = -PMB16,15,3 = ... = -PMB16,15,96. And if the branch metrics which is associated to the transition from the s'th state of the t'th stage to the l'th state of the (l+1)'th stage is denoted as BMs,l,t, and the output signal of the match filter which is associated to the transitions from the t'th stage to the (t+1)'th stage is denoted as MFt then BMs,l,t=MFt+PBMs,l,t.

The whole predetermined branch metric table can be stored within the data register file, thus there is no need to fetch portions of the predetermined branch metric table during stages 450-470. During step 410 the predetermined branch metric table is moved into a plurality of registers located in data register files 28,29. Preferably a portion of the branch metric table is moved to a plurality of registers located in the data register files 28,29. At step 410, eight predetermined branch metrics BM0-BM7, which are used in the next four ACS butterfly operations are moved into registers D4 and D5, from a predetermined location of internal memory module 20, that is pointed to by an effective address stored in register R1. The effective address is incremented by one.

As indicated by path 415, step 410 is followed by step 430, which is analogues to step 330 of method 300. As indicated by path 435, step 430 is followed by step 440.

During step 440, the "Add" operations for two ACS butterflies are performed in parallel, and preferably in the same single clock cycle. Four predetermined branch metrics are added to four path metrics. The "Add" operations which are performed during step 440 are analogues to the "Add" operations performed in step 340 of method 300.

As indicated by path 445, step 440 is followed by step 450 which is the first step of a DO loop for the ACS butterfly operation. During step 450 four path metrics are examined in view of four predetermined branch metrics to determine the four survivor path metrics and the corresponding trellis. Four flags, VF0-VF3 indicate which are the survivor paths. The "compare and select" operations which are performed during step 450 are analogues to the "compare and select" operations performed in step 350 of method 300.

During step 450, and if there are more ACS butterfly operations to perform, output signals of a matched filter and predetermined branch metrics required for the next two ACS butterfly operations are fetched from internal memory module 20 to a plurality of registers of the register data file.

As indicated by path 455, step 450 is followed by step 460 in which the survivor path metrics are updated by adding the output signal of the matched filter corresponding to the transition from the previous stage to the next stage to the survivor path metrics, and if there are more ACS butterfly operations to perform, the path metrics and survivor paths required for the next two ACS butterfly operations are fetched from internal memory module 20 to a plurality of registers of the register data file.

As indicated by paths 465 and 468, if there are more ACS operations to execute step 460 is followed by step 470, otherwise step 460 is followed by step 480.

During step 480 the survivor path is updated and the updated survivor path and the survivor path metrics are sent to internal memory module 20. The update operation and sending the data to internal memory module are analogues to the update and send operations which are executed in step 360 of method 300.

Step 470 is analogues to step 470 but further includes the performance of "add" operations for two ACS butterfly operations. As indicated by path 475, step 470 is followed by step 450.

Another exemplary assembly code (written in capital letters), is shown. This assembly code is analogues to the previous assembly code, but has further instructions for calculating of the branch metrics, and fetching output signals of a matched filter. This assembly code performs 8 ACS butterfly operations :

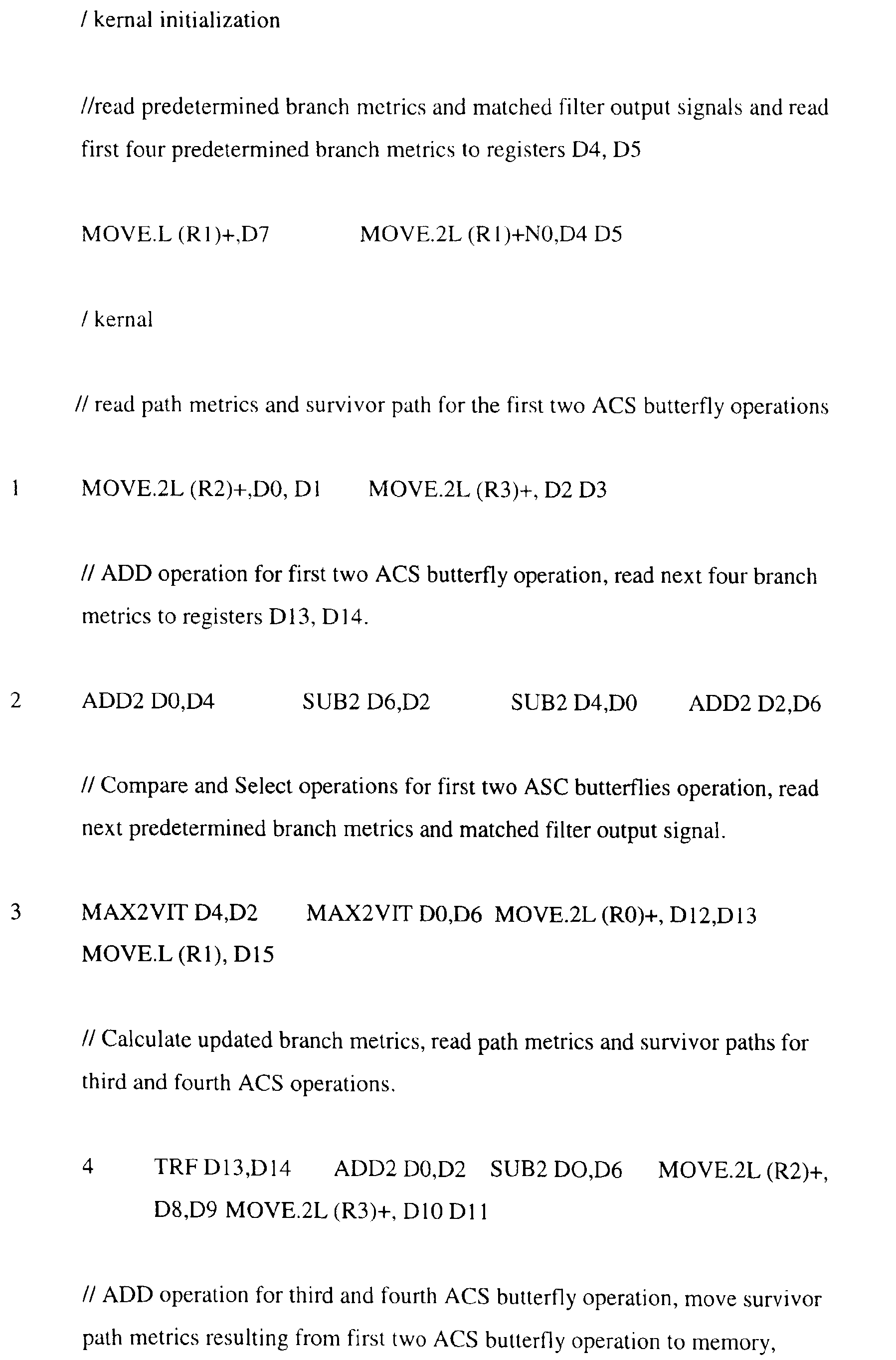

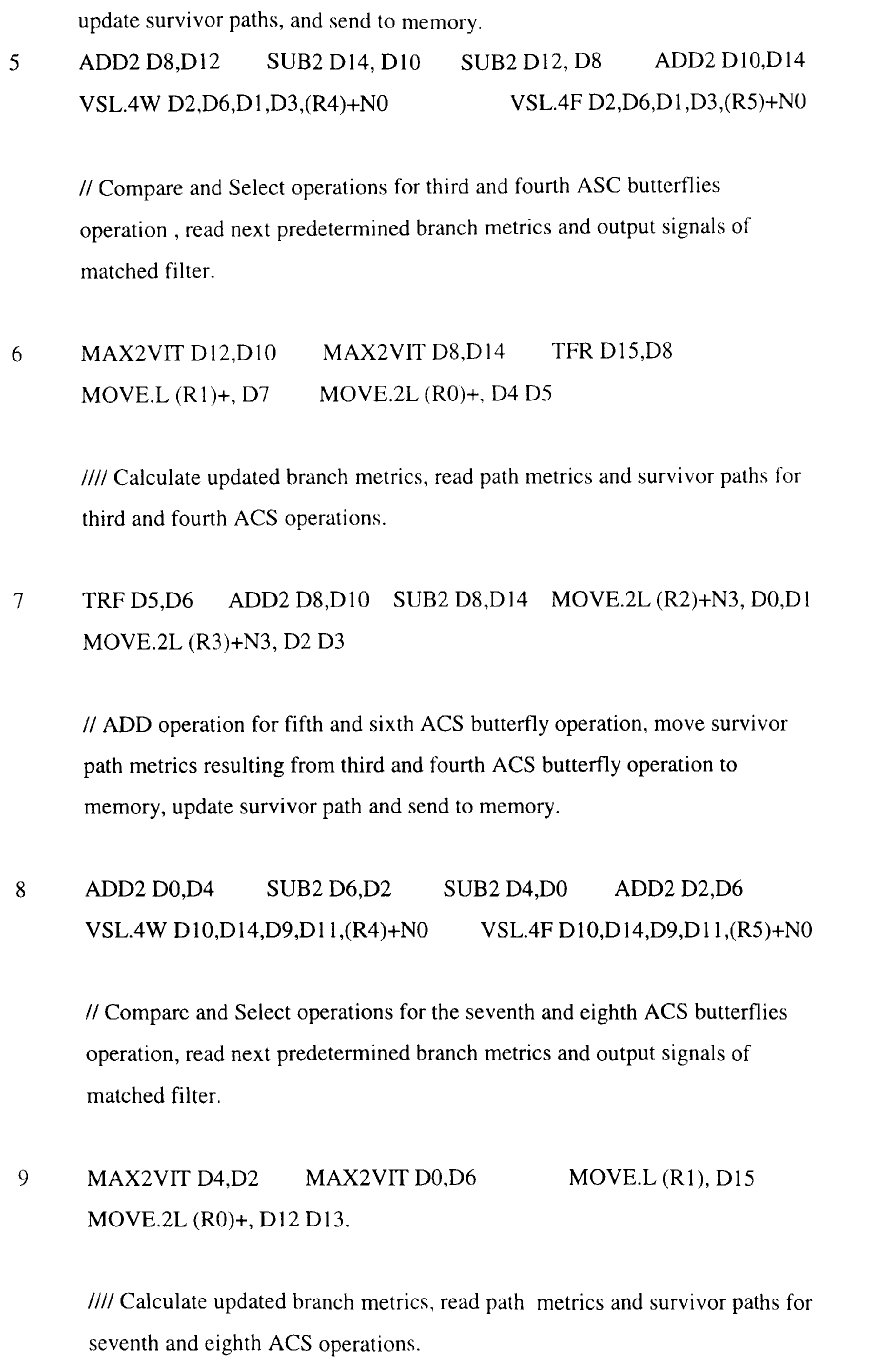

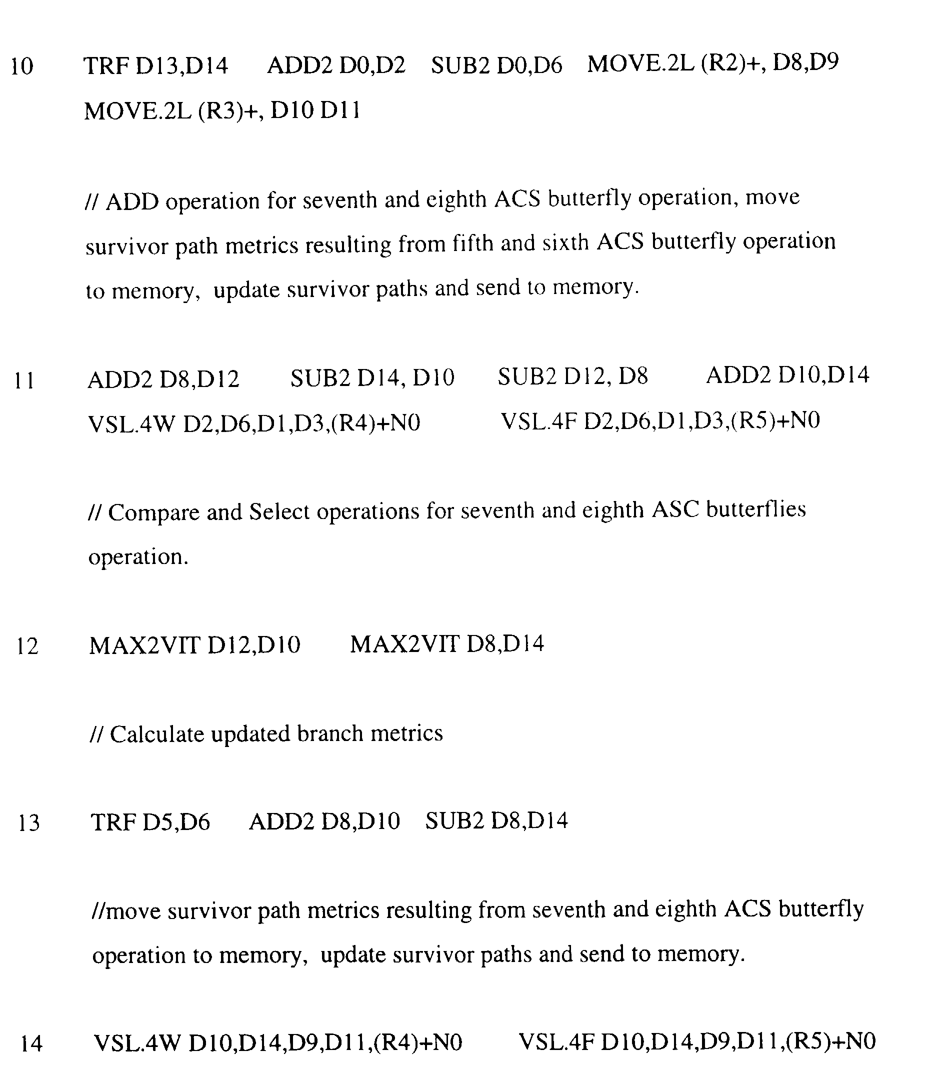

In a further embodiment of the invention, system 10 can perform simultaneously a plurality of ACS butterfly operations. For example, system 10 performs each of the "ADD", "Compare and Select" operations on L K-bit words in a single clock cycle, and simultaneously fetch the required data to perform the ACS butterfly operations. If K≥16 and L>4, the performance of L ACS butterflies operation requires to expand data buses 40 and 42, expand data register files 28,29 and to add more MAC 32 and AGU 30 units. For example, if L=4 and K=16, than system 10' can have 8 DALU units, 4 AGU units, and data buses 40 and 42 will be 128-bit wide. Thus, 4 branch metric required for 4 ACS butterflies when implementing a Viterbi decoder. Furthermore, either eight path metrics required for 4 ACS butterflies operations of a Viterby decoder or the 8 survivor metric paths and the survivor paths resulting from the execution of 4 ACS butterfly operations can be moved from and to the data register files and the internal memory module in a single clock cycle. System 10 can also have MAC units, which can perform "ADD" and "Select and compare" operations on J K-bit words. For example, if K=16 and J=4, than each MAC unit can handle simultaneously four 16-bit words. The instruction set will be altered, and instructions ADD2, SUB2, MAX2VIT will be changed to ADD4, SUB4, MAX2VIT, which will handle each of the four 16-bits words which are sent to the MAC unit separately. For example, when performing either of these instructions, the carry bits from the 15,31 and 47 bits will be disabled.

Thus, there has been described herein an embodiment including at least one preferred embodiment of an improved method for implementing a plurality of ACS butterfly operation in parallel in a data processing system. It will be apparent to those skilled in the art that the disclosed subject matter may be modified in numerous ways and may assume many embodiments other than the preferred form specifically set out and described above.

Accordingly, the above disclosed subject matter is to be considered illustrative and not restrictive, and to the maximum extent allowed by law, it is intended by the appended claims to cover all such modifications and other embodiments which fall within the true spirit and scope of the present invention. The scope of the invention is to be determined by the broadest permissible interpretation of the following claims and their equivalents rather than the foregoing detailed description.

## Claims

1. A method for performing, in parallel, a plurality of add-compare-select butterfly operations, the method comprising the steps of:
loading a plurality of branch metrics into a first storage element;
loading a plurality of previous path metrics and a plurality of previous survivor paths into a second storage element;
determining which of the plurality of the previous path metrics are the survivor paths using the plurality of branch metrics;
performing a logical left shift on the survivor paths, inserting a plurality of logic bits at the most least significant bits of the survivor paths, the logical bits indicates which signals was most likely generated by a convolutional encoder and received by a Viterbi decoder; and
storing the survivor path metrics and the survivor paths in a third storage element.

2. The method of claim 1 wherein while performing the step of determining which of the plurality of the previous path metrics are the survivor paths, performing at least one of the following steps :
(a) performing a logical left shift on the survivor paths which were generated in a previous add-compare-select butterfly operations, inserting a plurality of logic bits at the most least significant bits of the survivor paths, the logical bits indicates which signals was most likely generated by a convolutional encoder and received by the Viterbi decoder and
storing the survivor path metrics which were generated in a previous add-compare-select operation in a third storage element;
(Two) fetching branch metrics required to perform a next iterations of a plurality of add-compare-select butterfly operations, if these branch metrics were not previously fetched to the first storage element; and
(Three) loading previous path metric and previous survivor paths, required for performing a next iteration of L add-compare-select butterfly operations, into the second storage element.

3. The method of claim 2, wherein the step of determining which of two previous path metrics, out of the plurality of previous path metric, are the survivor paths comprises of the steps of :
adding a first branch metric to a first previous path metric to obtain a first result, storing the first set of result in the first storage element, subtracting the first branch metric from the first previous path metric to obtain a second result, and storing the result in the second storage element; and
comparing the first result and the second result, wherein the larger result is the survivor path metric.

4. The method of claim 2 wherein at least four add-compare select operations are performed in parallel.

5. A method for performing, in parallel, a plurality of add-compare-select butterfly operations, the method comprising the steps of:
loading a plurality of predetermined branch metrics and a plurality of output signals of a matched filter into a first storage element;
loading a plurality of previous path metrics and a plurality of previous survivor paths into a second storage element;
determining which of the plurality of the previous path metrics are the survivor paths using the plurality of predetermined branch metrics; wherein during the determination, producing a plurality of survivor path metrics;
adding to the plurality of survivor path metrics a corresponding output signal of the matched filter;
performing a logical left shift on the survivor paths, inserting a plurality of logic bits at the most least significant bits of the survivor paths, the logical bits indicates which signals was most likely corrupt by noise; and
storing the path metrics associated to the survivor paths and the survivor paths in a third storage element.

6. The method of claim 5 wherein while performing either the step of determining which of the plurality of the previous path metrics are the survivor paths and the step of adding to the plurality of survivor path metrics a corresponding output signal of the matched filter, performing at least one of the following steps :
(a) performing a logical left shift on the survivor paths which were generated in a previous add-compare-select butterfly operations, inserting a plurality of logic bits at the most least significant bits of the survivor paths, the logical bits indicates which signals was most likely corrupt by noise and
storing the survivor path metrics which were generated in a previous add-compare-select operation in a third storage element;
(Two) loading a plurality of predetermined branch metrics and a plurality of
output signals of a matched filter required to perform a next iterations of a plurality of add-compare-select butterfly operations, if these branch metrics were not previously fetched to the first storage element; and
(c) loading previous path metric and previous survivor paths, required for performing a next iteration of L add-compare-select butterfly operations, into the second storage element.

7. The method of claim 6, wherein the step of determining which of two previous path metrics, out of the plurality of previous path metric, are the survivor paths comprises of the steps of :
adding a first branch metric to a first previous path metric to obtain a first result, storing the first set of result in the first storage element, subtracting the first branch metric from the first previous path metric to obtain a second result, and storing the result in the second storage element; and
comparing the first result and the second result, wherein the larger result is the survivor path metric.

8. The method of claim 5 wherein at least four add-compare select operations are performed in parallel.

9. A data processing system, in particular a digital signal processor, having means for performing a method of anyone or more of the preceding claims.

10. A computer program for performing a method of anyone or more of the preceding claims.
